# EUROPÄISCHE PATENTSCHRIFT

(11) **EP 3 853 873 B1**
(45) Veröffentlichungstag und Bekanntmachung des Hinweises auf die Patenterteilung: **04.12.2024**
(21) Anmeldenummer: 19752476.2
(22) Anmeldetag: 07.08.2019
(51) Int. Cl.: H01C 1/14, H01C 1/148, H01C 3/12

(54) **WIDERSTANDSBAUELEMENT ZUR OBERFLÄCHENMONTAGE AUF EINER LEITERPLATTE UND LEITERPLATTE MIT ZUMINDEST EINEM DARAUF ANGEORDNETEN WIDERSTANDSBAUELEMENT**
RESISTOR COMPONENT FOR SURFACE MOUNTING ON A PRINTED CIRCUIT BOARD AND PRINTED CIRCUIT BOARD WITH AT LEAST ONE RESISTOR COMPONENT ARRANGED THEREON
COMPOSANT RÉSISTIF POUR MONTAGE EN SURFACE SUR UNE CARTE DE CIRCUIT IMPRIMÉ ET CARTE DE CIRCUIT IMPRIMÉ AVEC AU MOINS UN COMPOSANT RÉSISTIF AGENCÉ SUR CELLE-CI

(30) Priorität: 19.09.2018 DE 202018004354 U
(43) Veröffentlichungstag der Anmeldung: 28.07.2021
(73) Patentinhaber: Yageo Nexensos GmbH, 63801 Kleinostheim (DE)
(72) Erfinder: URFELS, Stephan, 63450 Hanau (DE); ASMUS, Tim, 63450 Hanau (DE); DIETMANN, Stefan, 63450 Hanau (DE); WIENAND, Karlheinz, 63741 Aschaffenburg (DE)
(74) Vertreter: Meissner Bolte Partnerschaft mbB
(86) Internationale Anmeldenummer: PCT/EP2019/071193
(87) Internationale Veröffentlichungsnummer: WO 2020/057850

(56) Entgegenhaltungen:
- EP-A2- 0 484 756
- EP-A2- 0 484 756
- JP-A- 2006 080 322
- JP-A- 2006 080 322
- JP-B2- 3 665 385
- JP-B2- 3 665 385
- KR-A- 20180 072 489
- KR-A- 20180 072 489
- RU-C1- 2 158 419
- RU-C1- 2 158 419

## Beschreibung

Die vorliegende Erfindung betrifft ein Widerstandsbauelement zur Oberflächenmontage auf einer Leiterplatte. Weiterhin betrifft die vorliegende Erfindung eine Leiterplatte mit zumindest einem darauf angeordneten Widerstandsbauelement. Die Dokumente KR20180072489A, RU2158419C1, JP2006080322A, JP3665385B2 stellen den nächstliegenden Stand der Technik dar.

In Leistungshalbleitermodulen werden elektronische Bauteile, wie beispielsweise Widerstandsbauelemente mittels Oberflächenmontage auf Leiterplatten gesetzt. Hierfür werden oft Widerstandsbauelemente, die keine Drahtanschlüsse besitzen, mittels lötfähiger Anschlussflächen direkt auf die Leiterplatte gelötet.

Sinterbare Widerstandbauelemente, wie beispielsweise Temperatursensoren oder Widerstände für die Leistungselektronik, können auch auf der Leiterplatte in Oberflächenmontage angeordnet werden. Hierzu werden üblicherweise zylindrische Bauelemente mit einer zum Sintern bestimmten, üblicherweise metallisierten und ebenen Unterseite mittels einer Sinterschicht, beispielsweiser einer silberhaltigen Sinterpaste mit einer Oberfläche der Leiterplatte elektrisch leitend verbunden. Die Kontaktierung kann mittels der metallisierten Unterseite und zumindest einem Kontaktpad, das auf einer der Unterseite gegenüberliegenden Oberseite des Widerstandsbauelements angeordnet ist, erfolgen. Um höhere elektrische Belastungen zu erreichen, kann die Kontaktierung auch durch zwei auf der Oberseite des Widerstandbauelements angeordnete Kontaktpads erfolgen, die elektrisch isoliert gegenüber der metallisierten Unterseite gehalten sind. Die oberseitige Kontaktierung der Kontaktpads erfolgt üblicherweise durch Drahtbonden, Löten, oder Sintern. Die DE102010050315B4 beschreibt beispielsweise ein elektrisches Bauelement mit Kontaktpads zur Kontaktierung auf der Oberseite des elektrischen Bauelements und einer gegenüberliegenden elektrisch isolierten Metallisierung zum Sintern auf potentialtragenden Flächen, wie beispielsweise auf eine Leiterbahn, die auf der Leiterplatte verläuft.

Die Kontaktflächen der aus dem Stand der Technik bekannten Widerstandsbauelemente zur Oberflächenmontage sind jedoch oft wegen den geringen Abmaßen des Widerstandsbauelements räumlich stark begrenzt ausgestaltet. Deshalb ist eine zuverlässige elektrische Kontaktierung der Kontaktpads nur schwierig zu erreichen.

Aufgabe der vorliegenden Erfindung ist es daher, ein verbessertes Widerstandsbauelement zur Oberflächenmontage auf einer Leiterplatte bereitzustellen.

Diese Aufgabe wird erfindungsgemäß durch ein Widerstandsbauelement gemäß des Gegenstands des Anspruchs 1 gelöst.

Das erfindungsgemäße Widerstandsbauelement zur Oberflächenmontage auf einer Leiterplatte weist hierfür auf:
ein Keramik-Substrat mit einer ersten Seite und einer gegenüberliegenden zweiten Seite, wobei auf der zweiten Seite eine sinterfähige Metallisierung zumindest bereichsweise angeordnet ist;
ein Widerstandselement aufweisend eine Metallschicht angeordnet zumindest bereichsweise auf der ersten Seite des Keramik-Substrats mit einem ersten Anschluss und einem zweiten Anschluss;
eine Isolationsschicht angeordnet zumindest bereichsweise auf dem Widerstandselement und dem Keramik-Substrat, wobei ein erster Bereich auf dem ersten Anschluss und ein zweiter Bereich auf dem zweiten Anschluss unbedeckt von der Isolationsschicht verbleibt; und
ein erstes Kontaktpad, das den ersten Anschluss über den ersten Bereich elektrisch kontaktiert, und ein zweites Kontaktpad das den zweiten Anschluss über den zweiten Bereich elektrisch kontaktiert, wobei das erste Kontaktpad einen ersten Oberflächenbereich der Isolationsschicht zumindest bereichsweise bedeckt und das zweite Kontaktpad einen zweiten Oberflächenbereich der Isolationsschicht zumindest bereichsweise bedeckt, und das erste und das zweite Kontaktpad voneinander räumlich getrennt auf der Isolationsschicht angeordnet sind.

Das Keramik-Substrat kann beispielsweise ein oder mehrere Materialien aus der Gruppe: Al2O3, AlSiC, AIN, B4C, BN, PBN, MgO, SiC, SiSiC, SSiC, Si3N4, YSZ oder PZT umfassen und plattenförmig bereitgestellt werden, zum Aufbau einer Vielzahl von Widerstandsbauelementen auf dem Keramik-Substrat. Nach dem Aufbau der Widerstandsbauelemente, kann das Keramik-Substrat strukturiert werden, um die einzelnen Widerstandsbauelemente zu erhalten. Die elektrisch isolierenden Eigenschaften des Keramik-Substrats ermöglichen eine Anordnung der Kontaktpads auf der ersten Seite des Keramik-Substrats, die elektrisch isolierend gegenüber der metallisierten zweiten Seite des Keramik-Substrats gehalten werden.

Die sinterfähige Metallisierung kann beispielsweise ein oder mehrere Materialien aus der Gruppe: NiAu, NiPdAu, AgPd, AuPd, Au, Ag oder Cu aufweisen und bereichsweise oder vollflächig auf der zweiten Seite des Keramik-Substrats angeordnet sein.

Das erfindungsgemäße Widerstandselement umfasst eine Metallschicht mit einem ersten Anschluss und einem zweiten Anschluss, bzw. wird mit der Metallschicht hergestellt. Die Metallschicht ist zumindest bereichsweise auf der ersten Seite des Keramik-Substrats angeordnet. Die Metallschicht kann als eine Leiterbahn ausgestaltet sein, die zwischen ihren Enden flächig, mäanderförmig oder wendelförmig verläuft und einen definierten Widerstandswert und Temperaturkoeffizient bei einer bestimmten Temperatur hat.

Als Isolationsschicht kann eine elektrisch isolierende Schicht, beispielsweise eine Glaskeramik, verstanden werden, die angeordnet ist auf Bereichen der Metallschicht und auf Bereichen der ersten Seite des Keramik-Substrats, die nicht von der Metallschicht bedeckt sind. Ein erster Bereich auf dem ersten Anschluss und ein zweiter Bereich auf dem zweiten Anschluss verbleiben unbedeckt von der Isolationsschicht. Beispielsweise kann die Isolationsschicht eine erste Seite des Keramik-Substrats bis auf den ersten Bereich über dem ersten Anschluss und dem zweiten Bereich über dem zweiten Anschluss vollständig bedecken. Der unbedeckte erste Bereich und zweite Bereich können als Öffnungen ausgestaltet sein, die eine elektrische Kontaktierung des jeweiligen Anschlusses ermöglicht, beispielsweise über einen Abschnitt eines elektrischen Leiters, der sich durch die Öffnungen in der Isolationsschicht erstreckt und eine Kontaktierung der Anschlüsse auf der der ersten Oberfläche des Keramik-Substrats abgewendeten Seite der Isolationsschicht ermöglicht. Die elektrische Kontaktierung der Anschlüsse kann auch durch direkt durch das Material der Kontaktpads hergestellt werden. Unter dem Begriff "Öffnung" kann auch eine Aussparung oder ein von der Isolationsschicht unbedeckter Bereich der unter der Isolationsschicht liegenden ersten Seite des Keramiksubstrats verstanden werden.

Die Kontaktpads decken jeweils einen Oberflächenbereich der Isolationsschicht ab. Als "Kontaktpad" kann eine dünne Schicht eines elektrisch leitenden Materials verstanden werden, dass im Wesentlichen eben auf der Oberfläche der Isolationsschicht angeordnet ist und mit einem Anschluss der Metallschicht indirekt oder direkt verbunden ist.

Unter "räumlich getrennt auf der Isolationsschicht angeordnet" kann eine Anordnung des ersten Kontaktpads und des zweiten Kontaktpads auf der Isolationsschicht verstanden werden, so dass sich die beiden Kontaktpads nicht berühren.

Mit der Erfindung ist es erstmalig gelungen ein Widerstandsbauelement zur Oberflächenmontage auf einer Leiterplatte zur Verfügung zu stellen mit Kontaktpads, die wegen ihrer Anordnung zumindest bereichsweise auf der Isolationsschicht eine ausreichend große Fläche für die Kontaktierung mit Dickdraht, beispielsweise mittels Ballbonding oder Wedgebonding bereitstellen.

In einem Beispiel bedecken der erste und der zweite Oberflächenbereich zusammen mindestens 70% einer Gesamtoberfläche der Isolationsschicht auf der ersten Seite des Keramik-Substrats.

Vorteilhaft steht bei dem erfindungsgemäßen Widerstandsbauelement fast der gesamte Oberflächenbereich der Isolationsschicht, die sich wiederum über die zweite Seite des Keramiksubstrats erstrecken kann, zur Verfügung. Somit kann die Oberfläche der Kontaktpads im Vergleich zu den aus dem Stand der Technik bekannten Widerstandsbauelementen erheblich vergrößert werden.

In einem Beispiel bedecken der erste und der zweite Oberflächenbereich zumindest bereichsweise eine Oberfläche der Isolationsschicht die parallel zu der ersten Seite des Keramik-Substrats mit dem darauf angeordneten Widerstandselement verläuft.

Vorteilhaft sind die Kontaktpads parallel zu der ersten Seite des Substrats und der Leiterplatte angeordnet. Diese Anordnung ermöglicht eine gute Kontaktierbarkeit mittels der bekannten Bonding-Verfahren.

In einem weiteren Beispiel bedecken der erste und der zweite Oberflächenbereich zumindest bereichsweise eine Oberfläche der Isolationsschicht die senkrecht zu der ersten Seite des Keramik-Substrats mit dem darauf angeordneten Widerstandselement verläuft.

Die Anordnung senkrecht zu der ersten Seite des Keramik-Substrats kann alternativ oder zusätzlich zu der Anordnung parallel zu der ersten Seite des Keramik-Substrats erfolgen.

Vorteilhaft kann durch eine Kombination der parallelen und seitlichen Anordnung der Oberflächenbereiche die Oberfläche der Kontaktpads weiter vergrößert werden.

In einem Beispiel sind/ist der erste und/oder der zweite Bereich unbedeckt von der Isolationsschicht in Form einer Öffnung in dem Material der Isolationsschicht ausgebildet.

Vorteilhaft umgibt das Material der Isolationsschicht die Öffnung auf dem wiederum die Kontaktpads angeordnet sein können. In einem Beispiel erstreckt sich das Material der Kontaktpads durch die Öffnungen, um somit die Anschlüsse des Widerstandselements elektrisch zu kontaktieren.

In einem alternativen Beispiel sind/ist der erste und der zweite Bereich unbedeckt von der Isolationsschicht an zwei gegenüberliegenden Enden des Keramik-Substrats angeordnet und die beiden Anschlüsse sind jeweils an einem der gegenüberliegenden Enden des Keramik-Substrats angeordnet.

Die Isolationsschicht ist in diesem Beispiel in einem mittleren Bereich auf dem Keramik-Substrat angeordnet und erstreckt sich nur bis zu den Anschlüssen des Widerstandselements. Die Öffnungen sind in diesem Beispiel an den Seiten der Isolationsschicht angeordnet.

In einem weiteren Beispiel deckt die Isolationsschicht die erste Seite des Keramik-Substrats mit dem darauf angeordneten Widerstandselement vollständig ab und der erste und/oder der zweite Bereich unbedeckt von der Isolationsschicht ist zumindest bereichsweise an dem Keramik-Substrat senkrecht zu der ersten Seite des Keramik-Substrats angeordnet und der erste und/oder der zweite Anschluss ist jeweils an einem von zwei gegenüberliegenden Enden des Keramik-Substrat senkrecht zu der ersten Seite des Keramik-Substrats angeordnet.

In einem weiteren Beispiel hat das Keramik-Substrat eine maximale Länge von 10 mm, eine maximale Breite von 5 mm und eine maximale Höhe von 3 mm.

In noch einem Beispiel umfasst die Isolationsschicht ein Glas oder ein Glaskeramik-Material.

Vorteilhaft kann durch eine Glaskeramik eine Isolationsschicht mit sehr guten Isolationseigenschaften geschaffen werden, die wegen der guten Isolationseigenschaften sehr dünn ausgestaltet sein kann.

In einem weiteren Beispiel ist der erste und der zweiten Oberflächenbereich angepasst zum Wedgebonding von Aluminiumdickdraht, insbesondere von Aluminiumdickdraht mit einem Durchmesser von größer oder gleich 25 µm.

In noch einem Beispiel umfasst die sinterfähige Metallisierung eine Silber-Palladium Metallisierung, und/oder das Keramik-Substrat umfasst eine Al2O3-Keramik.

In einem weiteren Beispiel umfasst die Metallschicht eine Strukturierung, ein PT100 oder PT1000 Widerstandselement, insbesondere ein Pt- Dünnschicht oder Dickschicht Widerstandselement mit Trimmstrecke, und ist angepasst zum Messen einer Temperatur, und wobei die Strukturierung der Metallschicht sich mäanderförmig zwischen dem ersten Anschluss und dem zweiten Anschluss erstreckt.

In noch einem Beispiel umfasst die Metallschicht ein Material mit einem Temperaturkoeffizienten von kleiner 500 ppm K⁻¹ bei Raumtemperatur, insbesondere Metalllegierungen enthaltend Chrom, Nickel, Eisen, Zink, Silber oder Palladium.

Die Erfindung schlägt auch eine Leiterplatte mit zumindest einem darauf angeordneten erfindungsgemäßen Widerstandsbauelement vor.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigen:
- Figuren 1a, 1b, 1c, 1d: schematische Ansichten eines Aufbaus eines Widerstandselements gemäß einer ersten Ausführungsform der Erfindung; und
- Figuren 2a, 2b, 2c, 2d: schematische Ansichten eines Aufbaus eines Widerstandselements gemäß einer zweiten Ausführungsform der Erfindung.

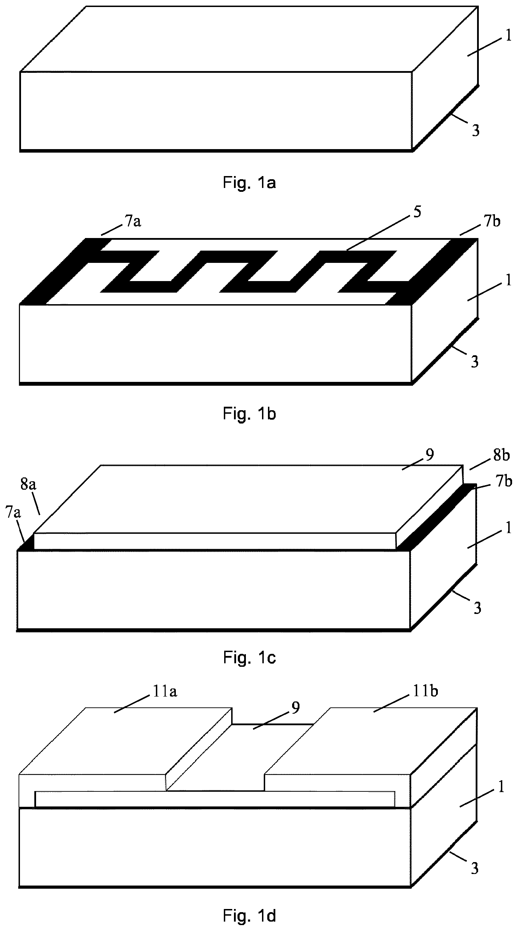

Figur 1a zeigt ein Keramik-Substrat 1 in Form eines Quaders gemäß einer ersten Ausführungsform der Erfindung. In der gezeigten Ausführungsform hat das Keramik-Substrat 1 eine maximale Länge von 10 mm, eine maximale Breite von 5 mm und eine maximale Höhe von 3 mm. In der gezeigten Ausführungsform kann das Keramik-Substrat 1 ein oder mehrere Materialien aus der Gruppe: Al2O3, AlSiC, AIN, B4C, BN, PBN, MgO, SiC, SiSiC, SSiC, Si3N4, YSZ oder PZT umfassen. Auf einer der ersten Seite, oder der Oberseite des Keramik-Substrats 1 die der zweiten Seite gegenüberliegt, ist eine sinterfähige Metallisierung 3 angeordnet. Die sinterfähige Metallisierung 3 kann in der gezeigten Ausführungsform ein Material oder mehrere Materialien aus der Gruppe: NiAu, NiPdAu, AgPd, AuPd, Cu, Au oder Ag aufweisen und kann vollflächig auf der zweiten Seite des Keramik-Substrats 1 angeordnet sein.

Figur 1b zeigt das zuvor in Figur 1a gezeigte Keramik-Substrat 1 mit einem Widerstandselement ausgebildet als eine strukturierte Metallschicht 5, die auf der ersten Seite des Keramik-Substrats 1 mit einem ersten Anschluss 7a und einem zweiten Anschluss 7b angeordnet ist.

Die Metallschicht 5 ist, wie in Figur 1b gezeigt, als eine Leiterbahn ausgestaltet, die zwischen ihren Enden, die durch den ersten Anschluss 7a und den zweiten Anschluss 7b gebildet werden, mäanderförmig verläuft und einen definierten Widerstandswert und Temperaturkoeffizienten bei einer bestimmten Temperatur hat. In der gezeigten Ausführungsform sind der erste Anschluss 7a und der zweite Anschluss 7b jeweils als ein streifenförmiger Leiterbahnabschnitt gezeigt. In weiteren Ausführungsformen kann der erste und der zweite Anschluss auch einfach durch die Leiterbahnenden der mäanderförmig angeordneten Leiterbahn gebildet werden.

Figur 1c zeigt die zuvor in Figur 1b gezeigte Anordnung mit einer Isolationsschicht 9 auf der Metallschicht 5 und der ersten Seite des Keramik-Substrats 1. Wie es in der Figur 1c gezeigt wird, ist ein erster Bereich 8a auf dem ersten Anschluss 7a und ein zweiter Bereich 8b auf dem zweiten Anschluss 7b unbedeckt von der Isolationsschicht 9. In der gezeigten Ausführungsform liegen sich der erste Bereich 8a und der zweite Bereich 8b gegenüber und der die Isolationsschicht 9 wird durch ein Glas oder Glaskeramik-Material gebildet.

Figur 1d zeigt die zuvor in Figur 1c gezeigte Anordnung mit einem ersten Kontaktpad 11a, das den ersten Anschluss 7a über den ersten Bereich 8a elektrisch kontaktiert, und ein zweites Kontaktpad 11b das den zweiten Anschluss 7b über den zweiten Bereich 8b elektrisch kontaktiert. Das Material der jeweiligen Kontaktpads 11a, 11b kontaktiert den jeweiligen Anschluss 7a, 7b, um eine elektrische Anbindung der Kontaktpads 11a, 11b an die Anschlüsse 7a, 7b zu erzielen.

Wie es in der Figur 1d gezeigt ist, bedecken die Kontaktpads 11a, 11b einen Bereich der Oberfläche der Isolationsschicht 9 der parallel zu der ersten Seite des Keramik-Substrats 1 mit dem darauf angeordneten Widerstandselement verläuft. In der gezeigten Ausführungsform bedecken die Kontaktpads 11a, 11b auch einen Bereich der Oberfläche der Isolationsschicht 9 der senkrecht zu der ersten Seite des Keramik-Substrats 1 verläuft.

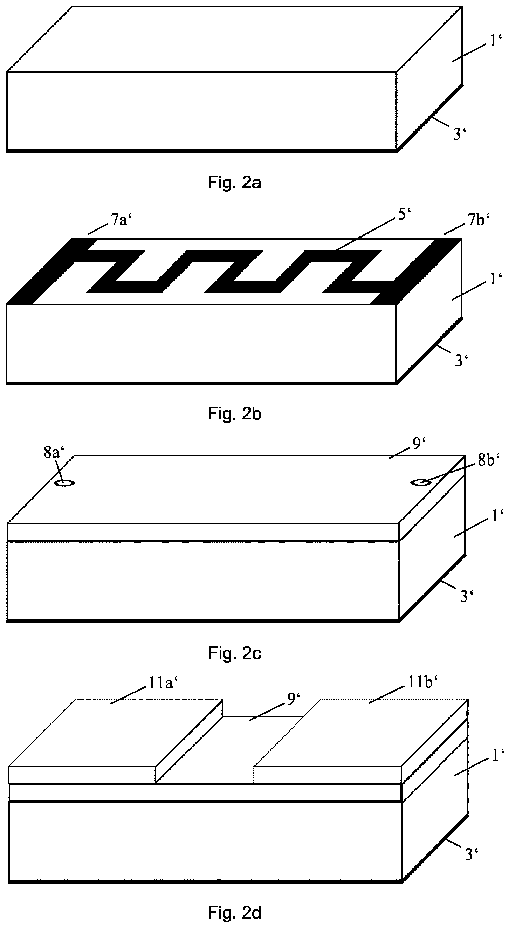

Die Figuren 2a, 2b, 2c, 2d zeigen weitere schematische Ansichten eines Aufbaus eines Widerstandselements gemäß einer zweiten Ausführungsform der Erfindung.

Die Figuren 2a und 2b entsprechen den bereits zuvor gezeigten Figuren 1a und 1b.

In der Figur 2c ist die Isolationsschicht im Wesentlichen vollflächig auf der ersten Seite des Keramik-Substrats 1' angeordnet und jeweils eine Ausnehmung 8a', 8b', in Form einer Öffnung, ist in dem Material der Isolationsschicht 9' angeordnet, um eine elektrische Kontaktierung der darunterliegenden Anschlüsse 7a', 7b' zu ermöglichen.

Wie es in der Figur 1c gezeigt wird, ist ein erster Bereich 8a' auf dem ersten Anschluss 7a' und ein zweiter Bereich 8b' auf dem zweiten Anschluss 7b' unbedeckt von der Isolationsschicht 9'. In der gezeigten Ausführungsform liegen sich der erste Bereich 8a' und der zweite Bereich 8b' gegenüber und die Isolationsschicht 9' wird durch ein Glas oder Glaskeramik-Material gebildet.

Die Anschlüsse 7a', 7b' können über einen elektrischen Leiter kontaktiert werden, der sich durch die Öffnungen erstreckt und mit dem Material der Kontaktpads 11 a', 11b' elektrisch in Kontakt steht. Alternativ kann sich auch ein Teil des Materials der Kontaktpads 11a', 11b' durch die Öffnungen erstrecken und mit den Anschlüsse 7a', 7b' direkt in elektrischem Kontakt stehen.

Wie es in der Figur 2d gezeigt wird, bedecken die Kontaktpads 11 a`, 11b' einen Bereich der Oberfläche der Isolationsschicht 9' der parallel zu der ersten Seite des Keramik-Substrats 1' mit dem darauf angeordneten Widerstandselement verläuft.

In einer weiteren (nicht gezeigten) Ausführungsform ist die Widerstandsschicht vollflächig und ohne Strukturierung auf dem Substrat ausgebildet.

### Bezugszeichenliste

- 1, 1': Keramik-Substrat
- 3, 3': sinterfähige Metallisierung
- 5, 5': Metallschicht
- 7a, 7a': erster Anschluss
- 7b, 7b': zweiter Anschluss
- 8a, 8a': erster Bereich
- 8b, 8b': zweiter Bereich
- 9, 9': Isolationsschicht
- 11a, 11a': erstes Kontaktpad
- 11b, 11b': zweites Kontaktpad

## Patentansprüche

1. Widerstandsbauelement zur Oberflächenmontage auf einer Leiterplatte, aufweisend:
ein Keramik-Substrat (1, 1 ') mit einer ersten Seite und einer gegenüberliegenden zweiten Seite, wobei auf der zweiten Seite eine sinterfähige Metallisierung (3, 3') zumindest bereichsweise angeordnet ist;
ein Widerstandselement aufweisend eine Metallschicht (5, 5') angeordnet zumindest bereichsweise auf der ersten Seite des Keramik-Substrats (1, 1') mit einem ersten Anschluss (7a, 7a') und einem zweiten Anschluss (7b, 7b');
eine Isolationsschicht (9, 9') angeordnet zumindest bereichsweise auf dem Widerstandselement und dem Keramik-Substrat (1, 1'), wobei ein erster Bereich (8a, 8a') auf dem ersten Anschluss (7a, 7a') und ein zweiter Bereich (8b, 8b') auf dem zweiten Anschluss (7b, 7b') unbedeckt von der Isolationsschicht (9, 9') verbleibt; und
ein erstes Kontaktpad (11a, 11a'), das den ersten Anschluss (7a, 7a') über den ersten Bereich (8a, 8a') elektrisch kontaktiert, und ein zweites Kontaktpad (11b, 11b') das den zweiten Anschluss (7b, 7b') über den zweiten Bereich (8b, 8b') elektrisch kontaktiert;
**dadurch gekennzeichnet, dass**
das erste Kontaktpad (11a, 11 a') einen ersten Oberflächenbereich der Isolationsschicht (9, 9') zumindest bereichsweise bedeckt und das zweite Kontaktpad (11b, 11b') einen zweiten Oberflächenbereich der Isolationsschicht (9, 9') zumindest bereichsweise bedeckt, und das erste (11a, 11a') und das zweite (11b, 11b') Kontaktpad voneinander räumlich getrennt auf der Isolationsschicht (9, 9') angeordnet sind.

2. Widerstandsbauelement nach Anspruch 1, **dadurch gekennzeichnet, dass** der erste und der zweite Oberflächenbereich zusammen mindestens 70% einer Gesamtoberfläche der Isolationsschicht (9, 9') auf der ersten Seite des Keramik-Substrats (1, 1') bedecken.

3. Widerstandsbauelement nach Anspruch 1 oder 2, **dadurch gekennzeichnet, dass** der erste und der zweite Oberflächenbereich zumindest bereichsweise eine Oberfläche der Isolationsschicht (9, 9') bedecken die parallel zu der ersten Seite des Keramik-Substrats mit dem darauf angeordneten Widerstandselement verläuft.

4. Widerstandsbauelement nach einem der vorangehenden Ansprüche, **dadurch**
**gekennzeichnet, dass**
der erste und der zweite Oberflächenbereich zumindest bereichsweise eine Oberfläche der Isolationsschicht (9) bedecken die senkrecht zu der ersten Seite des Keramik-Substrats (1) mit dem darauf angeordneten Widerstandselement verläuft.

5. Widerstandsbauelement nach einem der vorangehenden Ansprüche, **dadurch**
**gekennzeichnet, dass**
der erste (8a') und/oder der zweite (8b') Bereich unbedeckt von der Isolationsschicht (9') in Form einer Öffnung in dem Material der Isolationsschicht (9') ausgebildet ist.

6. Widerstandsbauelement nach einem der Ansprüche 1 bis 4, **dadurch gekennzeichnet, dass**
der erste (8a) und der zweite Bereich (8b) unbedeckt von der Isolationsschicht (9) an zwei gegenüberliegenden Enden des Keramik-Substrats (1) angeordnet sind und der erste (7a) und der zweite (7b) Anschluss jeweils an einem der zwei gegenüberliegenden Enden angeordnet ist.

7. Widerstandsbauelement nach einem der Ansprüche 1 bis 4, **dadurch gekennzeichnet, dass**
die Isolationsschicht (9') die erste Seite des Keramik-Substrats (1') mit dem darauf angeordneten Widerstandselement vollständig abdeckt und der erste (8a') und/oder der zweite Bereich (8b') unbedeckt von der Isolationsschicht (9') zumindest bereichsweise an dem Keramik-Substrat (1') senkrecht zu der ersten Seite des Keramik-Substrats (1') angeordnet ist und der erste und/oder der zweite Anschluss jeweils an einem von zwei gegenüberliegenden Enden des Keramik-Substrat senkrecht zu der ersten Seite des Keramik-Substrats (1, 1') angeordnet ist.

8. Widerstandsbauelement nach einem der vorangehenden Ansprüche, **dadurch**
**gekennzeichnet, dass**
das Keramik-Substrat (1, 1') eine maximale Länge von 10 mm, eine maximale Breite von 5 mm und eine maximale Höhe von 3 mm hat.

9. Widerstandsbauelement nach einem der vorangehenden Ansprüche, **dadurch**
**gekennzeichnet, dass**
die Isolationsschicht (9, 9') ein Glas oder ein Glaskeramik-Material umfasst.

10. Widerstandsbauelement nach einem der vorangehenden Ansprüche, **dadurch**
**gekennzeichnet, dass**
der erste und der zweiten Oberflächenbereich angepasst sind zum Wedgebonding von Aluminiumdickdraht, insbesondere von Aluminiumdickdraht mit einem Durchmesser von größer oder gleich 25 µm.

11. Widerstandsbauelement nach einem der vorangehenden Ansprüche, **dadurch**
**gekennzeichnet, dass**
die sinterfähige Metallisierung (3, 3') eine Silber-Palladium Metallisierung umfasst, und/oder das Keramik-Substrat (1, 1 ') eine Al2O3-Keramik umfasst.

12. Widerstandsbauelement nach einem der vorangehenden Ansprüche, **dadurch gekennzeichnet, dass**
die Metallschicht (5, 5') eine Strukturierung umfasst, ein PT100 oder PT1000 Widerstandselement umfasst, insbesondere ein Pt- Dünnschicht oder Dickschicht Widerstandselement mit Trimmstrecke, und angepasst zum Messen einer Temperatur, und wobei die Strukturierung der Metallschicht (5, 5') sich mäanderförmig zwischen dem ersten Anschluss (7a, 7a') und dem zweiten (7b, 7b') Anschluss erstreckt.

13. Widerstandsbauelement nach einem der Ansprüche 1 bis 11, **dadurch gekennzeichnet,**
**dass**
die Metallschicht (5, 5') ein Material mit einem Temperaturkoeffizienten von kleiner 500 ppm K⁻¹ bei Raumtemperatur umfasst, insbesondere Metalllegierungen enthaltend Chrom, Nickel, Eisen, Zink, Silber oder Palladium.

14. Leiterplatte mit zumindest einem darauf angeordneten Widerstandsbauelement nach einem der vorangehenden Ansprüche.

## Claims

1. A resistor component for surface mounting on a printed circuit board, comprising:
a ceramic substrate (1, 1') with a first side and an opposite second side, wherein a sinterable metallization (3, 3') is arranged at least in some regions on the second side;
a resistance element having a metal layer (5, 5') arranged at least in some regions on the first side of the ceramic substrate (1, 1') with a first connection (7a, 7a') and a second connection (7b, 7b');
an insulation layer (9, 9') arranged at least in some regions on the resistance element and the ceramic substrate (1, 1'), wherein a first region (8a, 8a') on the first connection (7a, 7a') and a second region (8b, 8b') on the second connection (7b, 7b') remain uncovered by the insulation layer (9, 9'); and
a first contact pad (11a, 11a') that electrically contacts the first connection (7a, 7a') via the first region (8a, 8a') and a second contact pad (11b, 11b') that electrically contacts the second connection (7b, 7b') via the second region (8b, 8b');
**characterized in that**
the first contact pad (11a, 11a') covers a first surface area of the insulation layer (9, 9') at least in some regions and the second contact pad (11b, 11b') covers a second surface area of the insulation layer (9, 9') at least in some regions, and **in that** the first contact pad (11a, 11a') and the second contact pad (11b, 11b') are arranged on the insulation layer (9, 9') such that they are spatially separated from one another.

2. The resistor component according to claim 1, **characterized in that** the first and the second surface area collectively cover at least 70 % of a total surface of the insulation layer (9, 9') on the first side of the ceramic substrate (1, 1').

3. The resistor component according to claim 1 or 2, **characterized in that** the first and the second surface area cover at least in some regions a surface of the insulation layer (9, 9'), which extends parallel to the first side of the ceramic substrate with the resistance element arranged thereon.

4. The resistor component according to one of the preceding claims, **characterized in that**
the first and the second surface area cover at least in some regions a surface of the insulation layer (9), which extends perpendicular to the first side of the ceramic substrate (1) with the resistance element arranged thereon.

5. The resistor component according to one of the preceding claims, **characterized in that**
the first region (8a') and/or the second region (8b') not covered by the insulation layer (9') is realized in the form of an opening in the material of the insulation layer (9').

6. The resistor component according to one of claims 1 to 4, **characterized in that**
the first region (8a) and the second region (8b) not covered by the insulation layer (9) are arranged on two opposite ends of the ceramic substrate (1) and the first connection (7a) and the second connection (7b) are respectively arranged on one of the two opposite ends.

7. The resistor component according to one of claims 1 to 4, **characterized in that**
the insulation layer (9') completely covers the first side of the ceramic substrate (1') with the resistance element arranged thereon, **in that** the first region (8a') and/or the second region (8b') not covered by the insulation layer (9') is arranged at least in some regions on the ceramic substrate (1') perpendicular to the first side of the ceramic substrate (1'), and **in that** the first connection and/or the second connection is respectively arranged on one of two opposite ends of the ceramic substrate perpendicular to the first side of the ceramic substrate (1, 1').

8. The resistor component according to one of the preceding claims, **characterized in that**
the ceramic substrate (1, 1') has a maximum length of 10 mm, a maximum width of 5 mm and a maximum height of 3 mm.

9. The resistor component according to one of the preceding claims, **characterized in that**
the insulation layer (9, 9') comprises a glass or glass ceramic material.

10. The resistor component according to one of the preceding claims, **characterized in that**
the first and the second surface area are adapted for wedge bonding of aluminum thick wire, particularly aluminum thick wire with a diameter greater than or equal to 25 µm.

11. The resistor component according to one of the preceding claims, **characterized in that**
the sinterable metallization (3, 3') comprises a silver-palladium metallization and/or the ceramic substrate (1, 1') comprises an Al2O3 ceramic.

12. The resistor component according to one of the preceding claims, **characterized in that**
the metal layer (5, 5') comprises a structuring, a PT100 or PT1000 resistance element, particularly a Pt thin layer or thick layer resistance element with trimming section, and is adapted for measuring a temperature, and **in that** the structuring of the metal layer (5, 5') extends between the first connection (7a, 7a') and the second connection (7b, 7b') in a meandering manner.

13. The resistor component according to one of claims 1 to 11, **characterized in that**
the metal layer (5, 5') comprises a material with a temperature coefficient of less than 500 ppm K⁻¹ at room temperature, particularly metal alloys containing chromium, nickel, iron, zinc, silver or palladium.

14. A printed circuit board with at least one resistor component according to one of the preceding claims arranged thereon.

## Revendications

1. Composant résistif pour le montage en surface sur une carte de circuit imprimé, comportant:
un substrat en céramique (1, 1') pourvu d'une première face et d'une deuxième face opposée, sur la deuxième face étant placée au moins par endroits une métallisation (3, 3') frittable;
un élément résistif comportant une couche métallique (5, 5'), placé au moins par endroits sur la première face du substrat en céramique (1, 1'), pourvu d'une première borne (7a, 7a') et d'une deuxième borne (7b, 7b');
une couche isolante (9, 9'), placée au moins par endroits sur l'élément résistif et sur le substrat en céramique (1, 1'), une première zone (8a, 8a') sur la première borne (7a, 7a') et une deuxième zone (8b, 8b') sur la deuxième borne (7b, 7b') restant non couverte par la couche isolante (9, 9'); et une première pastille de contact (11a, 11a'), qui contacte électriquement la première borne (7a, 7a') par l'intermédiaire de la première zone (8a, 8a') et une deuxième pastille de contact (11b, 11b') qui contacte électriquement la deuxième borne (7b, 7b') par l'intermédiaire de la deuxième zone (8b, 8b'); **caractérisé en ce que**
la première pastille de contact (11a, 11a') recouvre au moins par endroits une première zone superficielle de la couche isolante (9, 9') et la deuxième pastille de contact (11b, 11b') recouvre au moins par endroit une deuxième zone superficielle de la couche isolante (9, 9'), et **en ce que** des premiers (11a, 11a') et des deuxièmes (11b, 11b') pastilles de contact sont placées séparément les unes des autres sur la couche isolante (9, 9').

2. Composant résistif selon la revendication 1, **caractérisé en ce que**
la première et la deuxième zones superficielles recouvrent conjointement au moins 70 % d'une surface totale de la couche isolante (9, 9') sur la première face du substrat en céramique (1, 1').

3. Composant résistif selon la revendication 1 ou 2, **caractérisé en ce que**
la première et le deuxième zones superficielles recouvrent au moins par endroits une surface de la couche isolante (9, 9') qui s'écoule à la parallèle de la première face du substrat en céramique, avec l'élément résistif placé sur celle-ci.

4. Composant résistif selon l'une quelconque des revendications précédentes, **caractérisé en ce que**
la première et le deuxième zones superficielles recouvrent au moins par endroits une surface de la couche isolante (9) qui s'écoule à la perpendiculaire de la première face du substrat en céramique (1) avec l'élément résistif placé sur celle-ci.

5. Composant résistif selon l'une quelconque des revendications précédentes, **caractérisé en ce que**
la première (8a') et / ou la deuxième (8b') zone non couverte par la couche isolante (9') est conçue sous la forme d'un orifice dans la matière de la couche isolante (9').

6. Composant résistif selon l'une quelconque des revendications 1 à 4, **caractérisé en ce que**
la première (8a) et la deuxième zone (8b) non couverte par la couche isolante (9) sont placées sur deux extrémités opposées du substrat en céramique (1) et la première (7a) et le deuxième (7b) bornes sont placées chacune sur l'une des deux extrémités opposées.

7. Composant résistif selon l'une quelconque des revendications 1 à 4, **caractérisé en ce que**
la couche isolante (9') recouvre totalement la première face du substrat en céramique (1') avec l'élément résistif placé sur celle-ci et la première (8a') et / ou la deuxième zone (8b') non couverte par la couche isolante (9') est placée au moins par endroits sur le substrat en céramique (1'), à la perpendiculaire de la première face du substrat en céramique (1') et la première et / ou la deuxième borne est placée chaque fois sur l'une des deux extrémités opposées du substrat en céramique, à la perpendiculaire de la première face du substrat en céramique (1, 1').

8. Composant résistif selon l'une quelconque des revendications précédentes, **caractérisé en ce que**
le substrat en céramique (1, 1') a une longueur maximale de 10 mm, une largeur maximale de 5 mm et une hauteur maximale de 3 mm.

9. Composant résistif selon l'une quelconque des revendications précédentes, **caractérisé en ce que**
la couche isolante (9, 9') comprend un verre ou une matière vitrocéramique.

10. Composant résistif selon l'une quelconque des revendications précédentes, **caractérisé en ce que**
la première et la deuxième zones superficielles sont adaptées au soudage coin à coin de fil d'aluminium épais, notamment de fil d'aluminium épais d'un diamètre supérieur ou égal à 25 µm.

11. Composant résistif selon l'une quelconque des revendications précédentes, **caractérisé en ce que**
la métallisation (3, 3') frittable comprend une métallisation argent-palladium et / ou **en ce que** le substrat en céramique (1, 1') comprend une céramique Al2O3.

12. Composant résistif selon l'une quelconque des revendications précédentes, **caractérisé en ce que**
la couche métallique (5, 5') comprend une structuration, comprend un élément résistif PT100 ou PT1000, notamment un élément résistif à couche mince ou couche épaisse de Pt avec section de rognage et adapté pour mesurer une température et la structuration de la couche métallique (5, 5') s'étendant en forme de méandres entre la première borne (7a, 7a') et la deuxième (7b, 7b') borne.

13. Composant résistif selon l'une quelconque des revendications 1 à 11, **caractérisé en ce que**
la couche métallique (5, 5') comprend une matière d'un coefficient de température inférieur à 500 ppm K⁻¹ à température ambiante, notamment des alliages métalliques contenant du chrome, du nickel, du fer du zinc, de l'argent ou du palladium.

14. Carte de circuit imprimé, pourvue d'au moins un composant résistif selon l'une quelconque des revendications précédentes, placé sur celle-ci.
